Europäisches Patentamt

European Patent Office

Office européen des brevets

(19)

(11) **EP 1 242 180 B1**

(12) **EUROPÄISCHE PATENTSCHRIFT**

(45) Veröffentlichungstag und Bekanntmachung des Hinweises auf die Patenterteilung:
**20.10.2004  Patentblatt 2004/43**

(51) Int Cl.$^7$: **B01J 20/18**, B01J 20/28, B01D 53/28, H05B 33/04

(21) Anmeldenummer: **00991177.7**

(22) Anmeldetag: **12.12.2000**

(86) Internationale Anmeldenummer:
**PCT/EP2000/012604**

(87) Internationale Veröffentlichungsnummer:
**WO 2001/044107 (21.06.2001 Gazette 2001/25)**

(54) **PLÄTTCHENFÖRMIGE PRESSKÖRPER**

LAMINATED PRESSED ARTICLES

PIECE PRESSEE EN FORME DE PLAQUETTE

(84) Benannte Vertragsstaaten:
**AT BE CH CY DE DK ES FI FR GB GR IE IT LI LU MC NL PT SE TR**

(30) Priorität: **13.12.1999  DE 19959957**

(43) Veröffentlichungstag der Anmeldung:
**25.09.2002  Patentblatt 2002/39**

(73) Patentinhaber: **SÜD-CHEMIE AG**
**80333 München (DE)**

(72) Erfinder:
 • **DICK, Stefan**
  **86706 Weihering (DE)**
 • **LUONG, Tim**
  **St. José, CA 95133 (US)**
 • **MORGAN, Greg**
  **Sandia Park, NM 87047 (US)**
 • **SCHEPF, Arthur**
  **Belen, NM 87002 (US)**
 • **KIMURA, Tateshi**
  **Louisville, KY 40245 (US)**

(74) Vertreter: **Westendorp, Michael, Dr.**
**Patentanwälte**
**Splanemann Reitzner**
**Baronetzky Westendorp**
**Rumfordstrasse 7**
**80469 München (DE)**

(56) Entgegenhaltungen:
**EP-A- 0 716 140        WO-A-99/49964**
**DE-A- 3 738 916        US-A- 4 360 444**

 • **DATABASE WPI Section Ch, Week 198534 Derwent Publications Ltd., London, GB; Class A14, AN 1985-206036 XP002169091 & JP 60 129139 A (MATSUSHITA ELEC IND CO LTD), 10. Juli 1985 (1985-07-10)**
 • **PATENT ABSTRACTS OF JAPAN vol. 018, no. 262 (C-1201), 19. Mai 1994 (1994-05-19) & JP 06 039235 A (SUMITOMO CHEM CO LTD), 15. Februar 1994 (1994-02-15)**

EP 1 242 180 B1

**Beschreibung**

Die Erfindung bezieht sich auf plättchenförmige Presskörper (Wafer) auf der Basis eines anorganischen Sorbens und eines Bindemittels, mit einer Dicke von weniger als 700 μm, die sich durch eine hohe mechanische Festigkeit und geringe Sprödigkeit auszeichnen und die in der Lage sind, anorganische und organische Gase oder Dämpfe effektiv zu sorbieren.

Die Herstellung von Presskörpern, insbesondere von Tabletten, auf der Basis von Zeolithen und Bindemitteln ist bereits bekannt. So werden nach der JP-A-61 15 5216 Zeolith-Tabletten durch Vermischen eines Zeoliths, eines Bindemittels und eines Gleitmittels und Extrudieren des Gemischs hergestellt. Es handelt sich offenbar um Tabletten mit gleichen Abmessungen in allen Richtungen.

Aus der JP-A-56063818 ist die Herstellung von Zeolith-Tabletten zur Verwendung als Gasadsorbentien bekannt, wobei gepulverter und bei 105 bis 110°C getrockneter Zeolith mit 8.1 Gew.-% Bentonitpulver vermischt und mit einer 4%igen wäßrigen Harnstofflösung geknetet wird. Das Gemisch wird tablettiert, getrocknet und bei 510°C calciniert. Die Erhöhung der Druckfestigkeit ist durch den Harnstoffgehalt bedingt.

Aus der JP-A-55 16 5144 ist bekannt, Zeolithpulver für Kühlaggregate in Pulverform mit Bentonit und Wasser zu verkneten, das Gemisch zu extrudieren und runde Teilchen mit einem Durchmesser vom 0,8 bis 10 mm zu formen.

Nach der JP-A-55 10 4913 wird Zeolith in der Na-Form mit 25 Gew.-% Ton vermischt, mit Wasser verknetet, extrudiert, bei 650°C calciniert, in eine Calciumchlorid-Lösung getaucht, gewaschen, bei 110°C getrocknet und bei 400°C aktiviert. Die Tabletten werden als Trockenmittel verwendet.

Nach der JP-A-4 603 2572 wird Zeolithpulver mit Kaolin und Na-(oder $NH_4$-)-Hydroxyethylcellulose vermischt, geformt, getrocknet und bei 650°C calciniert, um die Festigkeit der Zeolith-Tabletten zu erhöhen.

Nach der JP-A-21 44 121 werden Deodorantien durch Extrudieren von Zeolithpulver oder -körnern mit Calciumchlorid oder Bentonit und Wasser extrudiert, worauf das Gemisch tablettiert und die Tabletten calciniert werden.

Nach der JP-A-63 218 234 werden Trockenmittel durch Extrudieren eines Gemisches aus mikroporösen Teilchen (z.B. Gips, Zement, keramischem Pulver) und einem anorganischen oder organischen Füllstoff, wie $CaCl_2$, LiCl, Bentonit, Zeolithen, PVA oder anderen wasserlöslichen Polymeren hergestellt. Das Gemisch wird tablettiert und dann ausgehärtet.

Nach der JP-A-60 132 643 werden Zeolith-Tabletten als Trockenmittel unter Verwendung vom 20% Sepiolith als Bindemittel hergestellt. Das Gemisch wird mit Wasser geknetet, tablettiert, bei 150°C getrocknet und bei 550°C calciniert. Die Tabletten haben im Vergleich zu Bentonit-Tabletten eine verbesserte Trockenwirkung.

Für den Einsatz unter räumlich beengten Verhältnissen und unter mechanischer Beanspruchung sind die nach dem Stand der Technik hergestellten Tabletten ungeeignet, da sie zu dick und zu schwer sind und masse- und oberflächenbezogen eine zu geringe Sorptionskraft für schädliche Gase und Dämpfe haben. Mit den Verfahren und Mischungen nach dem Stand der Technik werden zu spröde Presskörper erhalten, die insbesondere nach dem Brennen abbröckeln.

Es ist bekannt, dass elektrolumineszierende Geräte nur dann problemlos über eine längere Zeit funktionieren, wenn ein Trockenmittel anwesend ist. Dies ist auf die Empfindlichkeit der Elektroden, insbesondere der Kathoden, z. B. gegenüber Feuchtigkeit zurückzuführen (die Kathoden bestehen aus Caoder Mg-Legierungen). Deshalb werden diese Geräte unter Schutzgas möglichst gut versiegelt.

In der EP 500 382 A2 ist der Einsatz eines Feuchtigkeitsabsorbers in einem elektrolumineszierenden Gerät beschrieben. Das Trockenmittel in Form eines Pulvers oder kleiner Kügelchen wird dabei auf einen schwarzen Siliconharzüberzug aufgebracht. Nach der bevorzugten Ausführungsform ist das Trockenmittel in einem gasdurchlässigen Beutel eingefüllt.

In der US-A-5,882,761 ist ebenfalls der Einsatz eines Trockenmittels in einem elektroluminiszierenden Gerät beschrieben. Als bevorzugtes Trockenmittel wird BaO eingesetzt.

Die aus den vorstehenden Druckschriften bekannten Sorbentien haben den Nachteil, dass sie nur Wasserdampf sorbieren können. Ein Angriff auf die Kathoden kann aber auch durch andere Gase ausgelöst werden, die neben Wasser beim Abbinden des zum Versiegeln benutzten Epoxyharzes entstehen (Ammoniak, flüchtige Amine). Daneben führt auch die Einwirkung von Sauerstoff zum Versagen der luminiszenten Bauteile (Oxidation der Kathode).

Der vorliegenden Erfindung liegt die Aufgabe zugrunde, plättchenförmige Presskörper (Wafer) auf der Basis eines anorganischen Sorbens und eines anorganischen Bindemittels mit einer sehr geringen Dicke (weniger als 700 μm) bereitzustellen, die trotz ihrer geringen Dicke eine große Festigkeit haben und somit insbesondere in elektronische Bauteile eingebaut werden können, in denen nur ein beschränkter Platz zur Verfügung steht und die Erschütterungen ausgesetzt sein können (z.B. elektronische Anzeigevorrichtungen in Automobilen und Mobiltelefonen).

Diese Aufgabe wird erfindungsgemäß gelöst durch die Bereitstellung von plättchenförmigen Presskörpern (Wafer) auf der Basis mindestens eines anorganischen Sorbens und mindestens eines Bindemittels, mit einer Dicke von weniger als 700 μm, die durch Verpressen eines Gemisches, aus bzw. enthaltend das anorganische Sorbens, etwa 20 bis, 60 Gew.-% des Bindemittels und etwa. 10 bis 15 Gew.-% Wasser, bestimmt durch Trochnen bei 160°C, (bezogen auf das Gesamtgemisch) bei einem Druck von mindestens 70 MPa; und Calcinieren des erhaltenen grünen Presskörpers bei Temperaturen von mindestens etwa 500°C bis zur weitgehenden Entfernung des Wassergehalts erhältlich sind.

Die erfindungsgemäßen Presskörper (Wafer) weisen eine hohe Festigkeit, geringe Sprödigkeit, hohe Sorptionsgeschwindigkeit und hohe Sorptionskapazitäten bei geringer Masse auf. Sie zeigen eine geringe thermische Ausdehnung, keinen Abrieb und sind leicht durch Zugabe von Pigmenten bei der Herstellung färbbar.

Um erfindungsgemäße grüne Presskörper von ausreichender Festigkeit zu erhalten, ist die Einhaltung der angegebenen Grenzen für das Mischungsverhältnis von Sorbens, Bindemittel und Wasseranteil und der Pressdruck von außerordentlicher Bedeutung. Um den Einfluss des Mischungsverhältnisses von Sorbens und Bindemittel auf die Produkteigenschaften zu untersuchen ist es zweckmäßig, das Gewichtsverhältnis von trockenem Sorbens zu trockenem Bindemittel als Parameter heranzuziehen, um die unterschiedlichen Wassergehalte von verschiedenen Sorbentien und Bindern zu eliminieren. Zudem ist es vorteilhaft, bei der Berechnung oder Feststellung des Wassergehalts der Mischung nur den relativ locker gebundenen Anteil zu berücksichtigen, der durch Erhitzen auf 160°C bestimmt werden kann, da nur die Menge dieses Wassers Einfluss auf das Verhalten der Mischung beim Pressvorgang und auf die Qualität des Endprodukts hat, nicht aber das von Sorbens oder Bindemittel strukturell und stark gebundene Wasser.

Zur Erläuterung dieses Konzepts mögen die folgenden Beispiele dienen. Als Sorbens wird Zeolith 4A angenommen, der als kommerziell erhältliches Pulver einen Wassergehalt von 20 Gew.-% aufweist, der erst über 500°C vollständig entfernt werden kann. Als Bindemittel wird Bentonit verwendet, der als kommerziell erhältliches Pulver einen Wassergehalt von 12 Gew.-% aufweist, der bei 160°C vollständig entfernt werden kann. Dies ist dem Fachmann geläufig.

Werden entsprechend Anspruch 1 z.B. 70 Teile Zeolith 4A, 20 Teile Bentonit und 10 Teile Wasser gemischt, so beträgt das Gewichtsverhältnis von trockenem Sorbens zu trockenem Bindemittel

$$(0,8 * 70) / (0,88 * 20) = 3,2.$$

Der Wassergehalt, wie er durch Trocknen bei 160°C bestimmt werden kann, setzt sich zusammen aus dem Wasser, das der Mischung zugefügt wurde (10 Teile), sowie dem vom Bentonit locker gebundenen Wasser:

$$10 + (0,12 * 20) = 12,4.$$

Diese Mischung ist demgemäß durch ein Gewichtsverhältnis von trockenem Sorbens zu trockenem Bindemittel von 3,2 und einem Wassergehalt von 12,4 Gew.-% bestimmt.

Werden gemäß Anspruch 1 z.B. 25 Teile Zeolith 4A, 60 Teile Bentonit und 15 Teile Wasser gemischt, so beträgt das Gewichtsverhältnis von trockenem Sorbens zu trockenem Bindemittel

$$(0,8 * 25) / (0,88 * 60) = 0,4.$$

Der Wassergehalt, wie er durch Trocknen bei 160°C bestimmt werden kann, setzt sich zusammen aus dem Wasser, das der Mischung zugefügt wurde (15 Teile), sowie dem vom Bentonit locker gebundenen Wasser:

$$15 + (0,12 * 60) = 22,2.$$

Diese Mischung ist demgemäß durch ein Gewichtsverhältnis von trockenem Sorbens zu trockenem Bindemittel von 0,4 und einem Wassergehalt von 22,2 Gew.-% bestimmt.

Beim Calcinieren der Presskörper kann außer dem vom Bindemittel locker gebundenen Wasser und dem eventuell vom Sorbens stark gebundenen Wasser auch vom Bindemittel strukturell gebundenes Wasser abgegeben werden. Bei der Verwendung von Bentonit als Bindemittel werden bei der Calcinationstemperatur an oktaedrisch koordinierte Magnesium- und Aluminiumionen gebundene Hydroxylgruppen als Wasser abgespalten. Die Gesamtmenge des bei der Calcination abgegebenen Wassers hängt somit vom Verhältnis von Sorbens zu Bindemittel, von der Natur des Sorbens und des Bindemittels und der Menge des zugesetzten Wassers ab. Beispielsweise werden bei einer Mischung, die aus Zeolith 4A als Sorbens und Bentonit als Bindemittel gebildet wird, wobei das Mischungsverhältnis von trockenem Sorbens zu trockenem Bindemittel 1,3 und der Wassergehalt zwischen 8 und 20 Gew.-% beträgt, bei der Calcination etwa zwischen 20 und 32 Gew.-% als Wasser abgegeben.

Vorzugsweise werden die Presskörper so lange bei der Calcinationstemperatur oder einer anderen geeigneten erhöhten Temperatur gehalten, bis diese Menge an Wasser abgegeben wurde und Gewichtskonstanz erreicht ist. So wird nach einer bevorzugten Ausführungsform der Erfindung bis zu einem Restfeuchtegehalt von < 2 Gew.-% (bestimmt bei der Calcinationstemperatur) calciniert bzw. getrocknet.

Nach einer bevorzugten Ausführungsform der Erfindung betrifft diese somit plättchenförmige Presskörper (Wafer), enthaltend mindestens ein anorganisches Sorbens und mindestens ein Bindemittel, mit einer Dicke von weniger als 700 µm, wobei im Gemisch das Gewichtsverhältnis von trockenem Sorbens zu trockenem Bindemittel zwischen 3,2 und 0,4 liegt. Bevorzugt liegt der Wassergehalt des Gemisches, bestimmt bei 160°C, zwischen etwa 8 und 22 Gew.-%. Die Presskörper sind nach einem Verfahren erhältlich, bei dem das Gemisch, enthaltend anorganisches Sorbens, Bindemittel, Wasser und gegebenenfalls Presshilfsmittel bei einem Druck von mindestens 70 MPa verpresst werden und die erhaltenen grünen Presskörper bei Temperaturen von mindestens etwa 500°C calciniert werden. Vorzugsweise erfolgt die Calcinierung bis zur Gewichtskonstanz oder bis zu einer Restfeuchte von ≤ 2 Gew.-%, bestimmt bei der Calcinationstemperatur. Das bevorzugte Mischungsverhältnis von trockenem Sorbens zu trockenem Bindemittel liegt zwischen etwa 2,1 und 0,7.

Die erfindungsgemäßen Presskörper können in automatisierten Prozessen in großen Stückzahlen pro Zeiteinheit hergestellt werden. Sie sind leicht handhabbar und können beispielsweise mit Hilfe sog. "pick-and-place" Maschinen einem Vorratsbehälter entnommen und in ein elektronisches Gerät eingesetzt werden.

Die erfindungsgemäßen Presslinge sind in der Lage, neben Wasserdampf auch andere Gase (Ammoniak, Amine, Sauerstoff) zu sorbieren. Da sie eine hohe Sorptionskapazität besitzen, braucht das elektronische Gerät, in das sie eingesetzt werden, nicht völlig luftdicht abgeschlossen sein.

Vorzugsweise stellt das anorganische Sorbens einen natürlichen oder künstlichen Zeolith dar. Es können aber auch andere Sorbentien, wie amorphe Kieselsäure oder Aluminiumhydroxid sowie Gemische anorganischer Sorbentien verwendet werden.

Als Bindemittel kann im Prinzip jedes dem Fachmann auf diesem Gebiet geeignet erscheinende Bindemittel verwendet werden. Bevorzugt wird als Bindemittel ein smektitischer Ton, insbesondere Bentonit, verwendet. Ebenso ist der Einsatz weiterer anorganischer Bindemittel, z.B. Aluminiumoxidhydroxid (Pseudoboehmit) möglich. Es können aber auch organische Bindemittel auf Kohlenhydrat- oder Proteinbasis verwendet werden, z.B. Stärke, Cellulosederivate (wie CMC oder CEC), Casein oder auch synthetische Polymere wie PVA, PVP oder Polyphenole oder tanninhaltige Bindemittel (Quebracho). Es können auch Gemische verschiedener Bindemittel verwendet werden.

Durch den Zusatz des Bentonits zum Zeolith wird überraschenderweise das Sorptionsvermögen des letzteren nicht vermindert. Tatsächlich ist ein synergetischer Effekt festzustellen, d.h. die Wasserdampfaufnahme des Gemischs ist weitaus weniger reduziert als es rein rechnerisch zu erwarten wäre.

Die Dicke des Wafers beträgt vorzugsweise etwa 200 bis 400 µm, sein Bindemittelgehalt vorzugsweise etwa 40 bis 50 Gew.-%.

Gegenstand der Erfindung ist ferner ein Verfahren, insbesondere zur Herstellung der vorstehend definierten Presskörper, das dadurch gekennzeichnet ist, dass man ein Gemisch, enthaltend das anorganische Sorbens, etwa 20 bis 60 Gew.-% des Bindemittels und etwa 10 bis 15 Gew.-% Wasser, bestimmt durch Trochnen bei 160°C und 0 bis 5 Gew.-% eines oder mehrerer Presshilfsmittel bei einem Druck von mindestens etwa 70 MPa verpresst und den erhaltenen grünen Presskörper bei Temperaturen von mindestens etwa 500°C bis zur weitgehenden Entfernung des Wassergehalts calciniert. Falls der Wassergehalt des verwendeten Sorbens bzw. Bindemittels bereits ausreicht, ist keine zusätzliche Zugabe von Wasser erforderlich.

Nach einer bevorzugten Ausführungsform des Verfahrens liegt das Gewichtsverhältnis des trockenen Sorbens und des trockenen Bindemittels im Gemisch zwischen etwa 3,2 und 0,4. Der Wasser-gehalt des Gemisches, bestimmt durch Trocknen bei 160°C, liegt vorzugsweise zwischen etwa 8 und 22 Gew.-%.

Bevorzugte Verfahrensmaßnahmen bestehen darin, dass das Gemisch vorzugsweise bis auf einen Wassergehalt von etwa 10 bis 25 Gew.-%, insbesondere von etwa 12 Gew.-%, getrocknet wird, worauf das getrocknete Granulat vorzugsweise bis auf eine Teilchengröße von etwas unter 250 µm zerkleinert wird.

Es wurde gefunden, dass beim Verpressen des Gemisches zum Presskörper die besten Resultate erzielt werden können, wenn das Gemisch nicht mehr als 15 Gew.-%, vorzugsweise nicht mehr als 8 Gew.-%, insbesondere 0 Gew.-% an Partikeln > 250 µm, bevorzugt > 200 µm und besonders bevorzugt > 150 µm enthält. Zugleich sollte der Anteil an Partikeln < 45 µm nicht mehr als 50 Gew.-%, bevorzugt nicht mehr als 30 Gew.-%, und besonders bevorzugt nicht mehr als 20 Gew.-% betragen. Die so hergestellten Presskörper weisen besonders vorteilhafte physikalische und chemische Eigenschaften auf.

Der bevorzugt verwendete A-Zeolith ist in Pulverform erhältlich und hat einen Feuchtigkeitsgehalt von etwa 10 bis 22 Gew.-%. Der Zeolith wird mit Bentonitpulver mit einem Feuchtigkeitsgehalt von vorzugsweise etwa 10 bis 20, insbesondere 12 Gew.-% sowie mit Wasser vermischt und dieses Gemisch wird anschließend granuliert.

Der Wassergehalt des Gemischs hängt von den Eigenschaften des Bentonits ab; dem Bentonit/Zeolith-Gemisch sollte soviel Wasser zugesetzt werden, dass das Gemisch granuliert werden kann. Vorzugsweise verwendet man hierzu einen Intensivmischer. Der Bentonit hat vorzugsweise einen Montmorillonitgehalt von > 80 Gew.-%.

Als Presshilfsmittel wird vorzugsweise ein fettsaueres Salz eines 2- oder 3-wertigen Metalls, wie Calcium- oder Aluminiumstearat, verwendet.

Der bevorzugte Pressdruck beträgt etwa 100 bis 1300 MPa.

Die Presskörper werden bei etwa 500 bis 900 °C, vorzugsweise bei etwa 650°C calciniert, bis Gewichtskonstanz erreicht ist.

Die Presskörper können auch unter Vakuum calciniert werden, wodurch auch permanente Gase, wie Sauerstoff, sorbiert werden.

Ferner können die Presskörper färbende Pigmente, z.B. $Fe_3O_4$, enthalten.

Gegenstand der Erfindung ist ferner die Verwendung der vorstehend definierten Presskörper als Einsätze in elektronischen Geräten oder Bauteilen, wie Anzeigevorrichtungen, insbesondere in elektrolumineszierenden Bauteilen, wie organischen lichtemittierenden Dioden (LED). Sie können aber auch in feuchtigkeitsempfindlichen Flüssigkristall-Anzeigevorrichtungen (LCD) verwendet werden.

Diese Geräte oder Bauteile können durch anorganische oder organische Gase oder Dämpfe bei der Herstellung oder während des Gebrauchs in ihrer Funktion geschädigt werden und haben aufgrund ihrer Bauart nur ein sehr geringes Raumangebot für ein Sorptionsmittel.

Diese elektronischen Geräte oder Bauteile (z.B. Anzeigevorrichtungen in Kraftfahrzeugen und Mobiltelefonen) sind häufig starken Erschütterungen ausgesetzt, weshalb es wichtig ist, dass die Presskörper nicht zerbrechen oder zerbröseln. Aufgrund ihrer Festigkeit ist es nicht erforderlich, die Presskörper mit einer gasdurchlässigen Folie abzudecken, wodurch die Herstellung der elektonischen Bauteile vereinfacht wird.

Gegenüber BaO lässt sich eine deutliche Volumen- und Kostenreduktion des elektronischen Bauteils erreichen. So besitzen die Wafer massebezogen eine höhere Sorptionskapazität und -geschwindigkeit für Wasserdampf im benötigten Temperatur- und Feuchtigkeitsbereich innerhalb eines elektronischen Bauteils. Zudem muss beim Einsatz von BaO berücksichtigt werden, dass bei der Hydrationsreaktion eine Volumenzunahme des Materials um 100% eintritt; deshalb ist innerhalb des Bauteils zusätzliches Volumen für die Ausdehnung des Trockenmittels vorzusehen und zwischen BaO und der elektrolumineszierenden Schicht eine wasserdampfdurchlässige Folie anzubringen, die den Kontakt zwischen dem sich ausdehnenden und eventuell abbröckelnden Trockenmittel und der Schicht verhindert. Demgegenüber zeigen die Wafer bei der Wasserdampfaufnahme keine Volumenänderung und bleiben mechanisch stabil, so dass auf die Bereitstellung eines zusätzlichen Ausdehnungsvolumens innerhalb des Bauteils sowie die Anbringung einer Schutzfolie verzichtet werden kann.

BaO hat zusätzlich den Nachteil, dass es selbst und seine Hydratationsprodukte stark basisch reagieren; zudem erhitzt es es bei der Aufnahme von Feuchtigkeit lokal sehr stark und bei unmittelbarem Kontakt mit organischen Verbindungen neigt es zu Selbstentzündung. Dies schränkt die Auswahl an Polymeren für die oben erwähnte Schutzfolie auf sehr teure, z.B. Fluorpolymere, ein und erhöht so die Kosten des Bauteils. Zudem treten bei der Verwendung von BaO Entsorgungsprobleme auf, da es als gesundheitschädliche Chemikalie die Demontage, Wiederverwendung und Entsorgung der Einzelteile des elektronischen Bauteils stark erschwert.

Die erfindungsgemäßen Presskörper können aber auch anderweitig Verwendung finden, z.B. als Einsätze in Pharmaverpackungen, da hier nur ein begrenztes Volumen für die Aufnahme eines Trokkenmittels zur Verfügung steht.

Die Presskörper können in beliebigen Formen vorliegen, z.B. rund, quadratisch, dreieckig oder rechteckig sein oder auch Bohrungen und/oder Aussparungen enthalten. Die erfindungsgemäßen Presskörper sind staubfrei und abriebfest. Sie können in üblichen Pressautomaten in großer Stückzahl pro Zeiteinheit hergestellt werden. Bevorzugt werden Pressen mit Mehrfachwerkzeugen verwendet.

Die Erfindung ist durch die nachstehenden Beispiele erläutert:

Beispiel 1 (Vergleich)

75,2 kg Zeolith 4A (Wassergehalt 20%), 23,8 kg Bentonit (Wassergehalt 12%) und 1 kg Calciumstearat werden in einem Intensivmischer 2 Minuten gemischt. Dann wird Wasser bis zu einem starken Anstieg der Viskosität zugegeben und weitere 4 Minuten gemischt. Die Mischung wird bei 110°C auf einen Wassergehalt von 12% getrocknet und anschließend granuliert (Stokes Granulator) und gesiebt (250 µm). 0,22 g des Materials mit einer Partikelgröße < 250 µm werden mit einem Druck von 69 MPa zu einem runden Wafer gepresst. Die grünen Wafer werden bei 650°C drei Stunden lang calciniert, unter Feuchtigkeitsausschluss abgekühlt und luftdicht verpackt. Die Dicke der Wafer nimmt bei der Calcinierung um etwa 15 bis 25% ab.

| Produkteigenschaften: | |
| --- | --- |
| Dicke: Feuchte (nach der Calcinierung) | $300 \pm 50$ µm < 1% |
| Ausschuss bei der Produktion | > 90% |

(fortgesetzt)

| Produkteigenschaften: | |
|---|---|
| Falltest* | 100% Bruch, Wafer bröckelt am Rand ab |

*Als Maß für die Druckfestigkeit dient der sogenannte Falltest, wobei 100 calcinierte Presskörper (runde Scheiben mit einem Durchmesser von 27 mm) aus eine Höhe von 1 m mit der flachen Seite nach unten fallengelassen werden. Es wird der Prozentgehalt der gebrochenen Prüfkörper festgestellt.

## Beispiel 2 (Vergleich)

57 kg Zeolith 4A (Wassergehalt 20%), 42 kg Bentonit (Wassergehalt 12%) und 1 kg Calciumstearat werden in einem Intensivmischer 2 Minuten gemischt. Dann wird Wasser bis zu einem starken Anstieg der Viskosität zugegeben und weitere 4 Minuten gemischt. Die Mischung wird bei 110°C auf einen Wassergehalt von 12% getrocknet und anschließend granuliert (Stokes Granulator) und gesiebt (250 µm). 0,22 g des Materials mit einer Partikelgröße < 250 µm werden mit einem Druck von 69 MPa zu einem Wafer gepresst. Die grünen Wafer werden bei 650°C drei Stunden lang calciniert, unter Feuchtigkeitsausschluss abgekühlt und luftdicht verpackt.

| Produkteigenschaften: | |
|---|---|
| Dicke | $300 \pm 50$ µm |
| Feuchte (nach der Calcinierung) | < 1% |
| Ausschuss bei der Produktion | 75% |
| Falltest | 80% Bruch |

## Beispiel 3

57 kg Zeolith 4A (Wassergehalt 20%), 42 kg Bentonit (Wassergehalt 12%) und 1 kg Calciumstearat werden in einem Intensivmischer 2 Minuten gemischt. Dann wird Wasser bis zu einem starken Anstieg der Viskosität zugegeben und weitere 4 Minuten gemischt. Die Mischung wird bei 110°C auf einen Wassergehalt von 12% getrocknet und anschließend granuliert (Stokes-Granulator) und auf einem 250 µm-Sieb gesiebt. 0,22 g des Materials mit einer Teilchengröße < 250 µm werden mit einem Druck von 72 MPa zu einem Wafer gepresst. Die grünen Wafer werden wie nach Beispiel 2 weiterbehandelt:

| Produkteigenschaften: | |
|---|---|
| Dicke | $300 \pm 50$ µm |
| Feuchte (nach der Calcinierung) | < 1% |
| Ausschuss bei der Produktion | < 50% |
| Falltest | 60% Bruch |

## Beispiel 4

57 kg Zeolith 4A (Wassergehalt 20%), 42 kg Bentonit (Wassergehalt 12%) und 1 kg Calciumstereat werden in einem Intensivmischer 2 Minuten gemischt. Dann wird Wasser bis zu einem starken Anstieg der Viskosität zugegeben und weitere 4 Minuten gemischt. Die Mischung wird bei 110°C auf einen Wassergehalt von 12% getrocknet, anschließend granuliert (Stokes-Granulator) und auf einem 250 µm-Sieb gesiebt. 0,22 g des Materials mit einer Partikelgröße < 250 µm werden mit einem Druck von 350 MPa zu einem Wafer gepresst. Die grünen Wafer werden bei 650°C drei Stunden calciniert, unter Feuchtigkeitsausschluss abgekühlt und verpackt.

| Produkteigenschaften: | |
|---|---|
| Dicke: | $300 \pm 50$ µm |
| Feuchte (nach der Calcinierung): | < 1% |
| Ausschuss bei der Produktion: | < 25% |
| Falltest: | 15% Bruch |

(fortgesetzt)

| Produkteigenschaften: | | |
|---|---|---|
| Sorptionskapazität * | nach einer Stunde | 5,4 Gew.-% |
| | nach 5 Stunden | 7,2 Gew.-% |
| | nach 24 Stunden | 13,0 Gew.-% |

*Die Sorptionskapazität für Wasserdampf wird bei 25°C in einer Atmosphäre mit einer Luftfeuchtigkeit von 10% bestimmt.

Beispiel 5

Die Arbeitsweise von Beispiel 4 wurde mit der Abweichung wiederholt, dass die Calcinierung der grünen Wafer im Vakuum erfolgte. Die calcinierten Wafer hatten im wesentlichen die gleichen Produkteigenschaften wie die Wafer von Beispiel 4, zeigten jedoch zusätzlich eine Aufnahmekapazität für Sauerstoff von etwa 5 ml/g (in einer trokkenen Sauerstoffatmosphäre bestimmt).

Beispiel 6

56,5 kg Zeolith 4A (Wassergehalt 20%), 41,5kg Bentonit (Wassergehalt 12%), 1 kg Calciumstearat und 1 kg Quebracho werden in einem Intensivmischer 2 Minuten gemischt. Dann wird Wasser bis zu einem starken Anstieg der Viskosität zugegeben und weitere 4 Minuten gemischt. Die Mischung wird bei 110°C auf einen Wassergehalt von 12% getrocknet und anschließend granuliert (Stokes-Granulator) und gesiebt (250 µm). 0,22 g des Materials mit einer Partikelgröße < 250 µm werden mit einem Druck von 200 MPa zu einem Wafer gepresst. Die grünen Wafer werden bei 650°C drei Stunden calciniert, unter Feuchtigkeitsausschluss abgekühlt und verpackt.

| Produkteigenschaften: | |
|---|---|
| Dicke | $300 \pm 50$ µm |
| Feuchte (nach der Calcinierung) | < 1% |
| Ausschuss bei der Produktion | < 35% |
| Falltest | 10% Bruch |

Beispiel 7

Die Arbeitsweise von Beispiel 4 wurde mit der Abweichung wiederholt, dass der beim Verpressen angewendete Druck 1200 MPa beträgt. Der Falltest ergab 10% Bruch. Der Ausschuss lag bei < 10%.

Beispiel 8

Die Arbeitsweise von Beispiel 4 wurde mit der Abweichung wiederholt, dass 54 kg Zeolith 4A, 40 kg Bentonit 5 kg $Fe_3O_4$ und 1 kg Calciumstereat verwendet wurden. Die erhaltenen Wafer waren dunkel gefärbt und konnten in einem LED-Display als Kontrastfläche verwendet werden.

Beispiel 9

57 kg Zeolith 4A (Wassergehalt 20%), 42 kg einer 50/50 Mischung aus Attapulgit und Kaolin (Wassergehalt 12%) und 1 kg Calciumstearat werden in einem Intensivmischer 2 Minuten gemischt. Dann wird Wasser bis zu einem starken Anstieg der Viskosität zugegeben und weitere 4 Minuten gemischt. Die Mischung wird auf einen Wassergehalt von 12% getrocknet, anschließend granuliert und auf einem 150 µm Sieb gesiebt. 0,17 g des Materials mit einer Partikelgröße < 150 µm werden mit einem Druck von 200 MPa zu einem Wafer gepresst. Die grünen Wafer werden bei 650°C drei Stunden calciniert, unter Feuchtigkeitsausschluss abgekühlt und verpackt.

| Produkteigenschaften: | |
|---|---|
| Dicke | $300 \pm 50$ µm |
| Feuchte (nach der Calcinierung) | < 1% |
| Ausschuss bei der Produktion | 25% |

(fortgesetzt)

| Produkteigenschaften: | |
|---|---|
| Falltest | 70% Bruch |

Beispiel 10

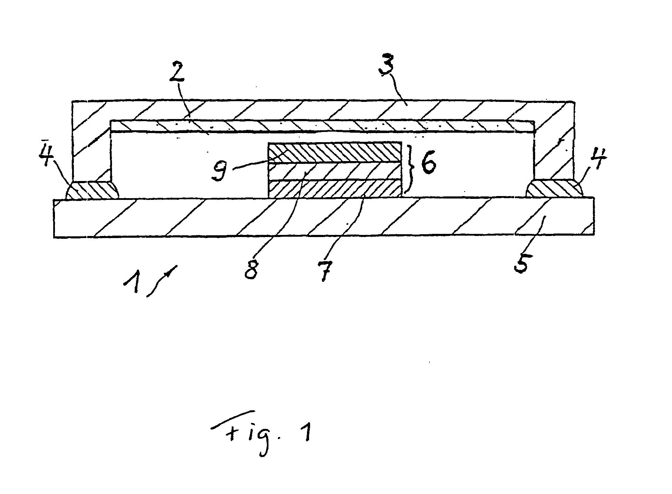

Ein organisches elektroluminiszierendes Bauteil 1 (quadratisch, Fläche 12,9 cm$^2$), wie in Abbildung 1 gezeigt, wird unter Verwendung eines Wafers (kreisrund, Durchmesser 27mm) von Beispiel 4 hergestellt. Nach der Befestigung des Wafers 2 an der Rückwand 3 des Bauteils wird dieser mit Hilfe eines Klebstoffs 4 am Glassubstrat 5 des Bauteils befestigt und so weit wie möglich mit Hilfe des Klebstoffs versiegelt. Anschließend wird eine mikroskopische Photographie (Vergrößerung 50-fach) des lichtemittierenden Teils 6 (bestehend aus der Anode 7, der lichtemittierenden Schicht 8 und der Kathode 9) des Bauteils aufgenommen. Diese Photographie zeigt keine dunklen (nichtleuchtenden) Flecken, die auf einen Angriff auf die Kathode 9 hinweisen würden.

Das Bauteil wird 500 h einer Temperatur von 85°C und einer relativen Luftfeuchtigkeit von 85% ausgesetzt. Anschließend wird erneut eine mikroskopische Photographie des lichtemittierenden Teils 6 des Bauteils 1 aufgenommen. Ein Vergleich der beiden Photographien zeigt, dass keine dunklen Flecken entstanden sind, die auf einen Angriff auf die Kathode 9 hinweisen würden.

Beispiel 11 (Vergleich)

Ein organisches elektroluminiszierendes Bauteil 1 wie Beispiel 9 wird unter Verwendung von BaO hergestellt. Als Abdeckung für das BaO wird eine wasserdurchlässige Teflonfolie verwendet, die mit Hilfe eines dünnen Doppelklebebandes an der Rückwand 3 des Bauteils befestigt wird. Die Menge an BaO wird so eingestellt, dass die Gesamtmasse an BaO, der Teflonfolie und des Doppelklebebandes genau der eines in Beispiel 9 verwendeten Wafers entspricht. Anschließend werden, wie in Beispiel 9 beschrieben, vergrößerte Photographien des lichtemittierenden Teils vor und nach einer Lagerung von 500 h bei 85°C und 85% Luftfeuchtigkeit aufgenommen. Ein Vergleich der beiden Photographien zeigt eine deutlich erkennbares Wachstum dunkler Punkte, die auf einen Angriff auf die Kathode 9 hinweisen.

**Patentansprüche**

1. Plättchenförmige Presskörper (Wafer) auf der Basis mindestens eines anorganischen Sorbens und mindestens eines Bindemittels, mit einer Dicke von weniger als 700 µm, erhältlich durch Verpressen eines Gemisches, enthaltend das anorganische Sorbens, etwa 20 bis 60 Gew.-% des Bindemittels, etwa 10 bis 15 Gew.-% Wasser, bestimmt durch Trocknen bei 160°C, (bezogen auf das Gesamtgemisch) und ein Presshilfsmittel bei einem Druck von mindestens 70 MPa; und Calcinieren des erhaltenen grünen Presskörpers bei Temperaturen von mindestens etwa 500°C, bis zur weitgehenden Entfernung des Wassergehalts.

2. Presskörper nach Anspruch 1, **dadurch gekennzeichnet, dass** im Gemisch das Gewichtsverhältnis des trockenen Sorbens und des trockenen Bindemittels zwischen etwa 3,2 und 0,4 liegt.

3. Presskörper nach Anspruch 1 oder 2, **dadurch gekennzeichnet, dass** die Calcinierung bis zur Gewichtskonstanz oder bis zu einer Restfeuchte von < 2 Gew.-%, bestimmt bei der Calcinationstemperatur, durchgeführt wird.

4. Presskörper nach einem der Ansprüche 1 bis 3, **dadurch gekennzeichnet, dass** das anorganische Sorbens einen natürlichen oder künstlichen Zeolith darstellt.

5. Presskörper nach einem der Ansprüche 1 bis 4, **dadurch gekennzeichnet, dass** das Bindemittel einen smektitischen Ton, vorzugsweise Bentonit, darstellt.

6. Presskörper nach einem der Ansprüche 1 bis 5, **dadurch gekennzeichnet, dass** die Dicke des Wafers etwa 200 bis 400 µm beträgt.

7. Presskörper nach einem der Ansprüche 1 bis 6, **dadurch gekennzeichnet, dass** sein Bindemittelgehalt etwa 40 bis 50 Gew.-% beträgt.

**8.** Presskörper nach einem der Ansprüche 1 bis 7, **dadurch gekennzeichnet, dass** der Druck etwa 100 bis 1300 MPa beträgt.

**9.** Presskörper nach einem der Ansprüche 1 bis 8, **dadurch gekennzeichnet, dass** er mit einem fettsauren Salz eines 2- oder 3-werteigen Metalls als Presshilfsmittel verpresst worden ist.

**10.** Presskörper nach einem der Ansprüche 1 bis 9, **dadurch gekennzeichnet, dass** er mit einem tanninhaltigen Bindemittel, vorzugsweise Quebracho, verpresst worden ist.

**11.** Presskörper nach einem der Ansprüche 1 bis 10, **dadurch gekennzeichnet, dass** er unter Vakuum calciniert worden ist.

**12.** Presskörper nach einem der Ansprüche 1 bis 11, **dadurch gekennzeichnet, dass** er ein färbendes Pigment enthält.

**13.** Presskörper mit den Feststoffkomponenten nach einem der Ansprüche 1 bis 12, wobei der Wassergehalt des Gemisches, bestimmt durch Trocknen bei 160°C, vorzugsweise zwischen etwa 12,4 und etwa 22 Gew.-%, jedoch allgemein zwischen etwa 8 und 22% Gew.-% liegt.

**14.** Verfahren zur Herstellung von plättchenförmigen Presskörpern mit einer Dicke von weniger als 700 μm, **dadurch gekennzeichnet, dass** man ein Gemisch, enthaltend mindestens ein anorganisches Sorbens, etwa 20 bis 60 Gew.-% mindestens eines Bindemittels, etwa 10 bis 15 Gew.-% Wasser, bestimmt durch Trocknen bei 160°C, und ein Presshilfsmittel bei einem Druck von mindestens etwa 70 MPa verpresst und den erhaltenen grünen Presskörper bei Temperaturen von mindestens etwa 500°C bis zur weitgehenden Entfernung des Wassergehalts calciniert.

**15.** Verfahren nach Anspruch 14, **dadurch gekennzeichnet, dass** im Gemisch das Gewichtsverhältnis des trockenen Sorbens und des trockenen Bindemittels zwischen etwa 3,2 und 0,4 liegt.

**16.** Verfahren nach Anspruch 14 oder 15, **dadurch gekennzeichnet, dass** die Calcinierung bis zur Gewichtskonstanz oder bis zu einer Restfeuchte von < 2%, bestimmt bei der Calcinationstemperatur, durchgeführt wird.

**17.** Verfahren nach einem der Ansprüche 14 bis 16, **dadurch gekennzeichnet, dass** man einen oder mehrere der in einem der Ansprüche 2 bis 13 angegebenen Bestandteile unter den dort angegebenen Bedingungen verwendet.

**18.** Verfahren nach einem der Ansprüche 14 bis 17, wobei der Wassergehalt des Gemisches, bestimmt durch Trocknen bei 160°C, vorzugsweise zwischen etwa 12,4 und etwa 22 Gew.-%, jedoch allgemein zwischen etwa 8 und 22% Gew.-% liegt.

**19.** Verwendung des Presskörpers nach einem der Ansprüche 1 bis 13 als Einsatz in elektronischen Geräten, wie Anzeigenvorrichtungen, insbesondere in elektrolumineszierenden Bauteilen.

**Claims**

**1.** Lamellar pressed articles (wafers) based on at least one inorganic sorbent and at least one binder, having a thickness of less than 700 μm, obtainable by pressing a mixture containing the inorganic sorbent, approximately 20 to 60 wt.% of the binder, approximately 10 to 15 wt.% of water, determined by drying at 160°C, (relative to the total mixture) and a pressing auxiliary at a pressure of at least 70 MPa; and calcining the green pressed article obtained at temperatures of at least approximately 500°C, until the water content has been extensively removed.

**2.** A pressed article according to claim 1, **characterised in that** the weight ratio of the dry sorbent and the dry binder in the mixture is between approximately 3.2 and 0.4.

**3.** A pressed article according to claim 1 or claim 2, **characterised in that** calcining is performed to a constant weight or to a residual moisture level of < 2 wt.%, determined at the calcination temperature.

**4.** A pressed article according to one of claims 1 to 3, **characterised in that** the inorganic sorbent is a natural or synthetic zeolite.

5.  A pressed article according to any one of claims 1 to 4, **characterised in that** the binder is a smectic clay, preferably bentonite.

6.  A pressed article according to any one of claims 1 to 5, **characterised in that** the thickness of the wafer amounts to approximately 200 to 400 μm.

7.  A pressed article according to any one of claims 1 to 6, **characterised in that** its binder content amounts to approximately 40 to 50 wt.%.

8.  A pressed article according to any one of claims 1 to 7, **characterised in that** the pressure amounts to approximately 100 to 1300 MPa.

9.  A pressed article according to any one of claims 1 to 8, **characterised in that** it has been pressed with a fatty acid salt of a di- or trivalent metal as pressing auxiliary.

10. A pressed article according to any one of claims 1 to 9, **characterised in that** it has been pressed with a tannin-containing binder, preferably quebracho.

11. A pressed article according to any one of claims 1 to 10, **characterised in that** it has been calcined under a vacuum.

12. A pressed article according to any one of claims 1 to 11, **characterised in that** it contains a colour-imparting pigment.

13. A pressed article having the solids components according to any one of claims 1 to 12, wherein the water content of the mixture, determined by drying at 160°C, is preferably between approximately 12.4 and approximately 22 wt.%, but generally between approximately 8 and 22 wt.%.

14. A method of producing lamellar pressed articles having a thickness of less than 700 μm, **characterised in that** a mixture containing at least one inorganic sorbent, approximately 20 to 60 wt.% of at least one binder, approximately 10 to 15 wt.% of water, determined by drying at 160°C, and a pressing auxiliary is pressed at a pressure of at least approximately 70 MPa and the green pressed article obtained is calcined at temperatures of at least approximately 500°C, until the water content has been extensively removed.

15. A method according to claim 14, **characterised in that** the weight ratio of the dry sorbent and the dry binder in the mixture is between approximately 3.2 and 0.4.

16. A method according to claim 14 or claim 15, **characterised in that** calcining is performed to a constant weight or to a residual moisture level of < 2%, determined at the calcination temperature.

17. A method according to any one of claims 14 to 16, **characterised in that** one or more of the constituents indicated in any one of claims 2 to 13 is/are used under the conditions indicated therein.

18. A method according to any one of claims 14 to 17, wherein the water content of the mixture, determined by drying at 160°C, is preferably between approximately 12.4 and approximately 22 wt.%, but generally between approximately 8 and 22 wt.%.

19. Use of the pressed article according to any one of claims 1 to 13 as an insert in electronic devices, such as display devices, in particular in electroluminescent components.

**Revendications**

1.  Corps pressé en forme de plaque (plaquette) à base d'au moins un absorbant inorganique et d'au moins un liant, présentant une épaisseur inférieure à 700 μm, pouvant être obtenu par compression d'un mélange contenant l'absorbant inorganique, environ 20 à 60% en poids du liant, environ 10 à 15% en poids d'eau, déterminé par séchage à 160°C (par rapport au mélange total), et un adjuvant de compression, à une pression d'au moins 70 MPa ; et calcination du corps pressé cru obtenu à des températures d'au moins environ 500°C jusqu'à une large élimination de la teneur en eau.

**2.** Corps pressé selon la revendication 1, **caractérisé en ce que**, dans le mélange, le rapport pondéral de l'absorbant sec et le liant sec est situé entre environ 3,2 et 0,4.

**3.** Corps pressé selon la revendication 1 ou 2, **caractérisé en ce que** la calcination est réalisée jusqu'à poids constant ou jusqu'à une humidité résiduelle <2% en poids, déterminée à la température de calcination.

**4.** Corps pressé selon l'une quelconque des revendications 1 à 3, **caractérisé en ce que** l'absorbant inorganique est une zéolithe naturelle ou artificielle.

**5.** Corps pressé selon l'une quelconque des revendications 1 à 4, **caractérisé en ce que** le liant est une argile de type smectite, de préférence la bentonite.

**6.** Corps pressé selon l'une quelconque des revendications 1 à 5, **caractérisé en ce que** l'épaisseur de la plaquette est d'environ 200 à 400 µm.

**7.** Corps pressé selon l'une quelconque des revendications 1 à 6, **caractérisé en ce que** sa teneur en liant est d'environ 40 à 50% en poids.

**8.** Corps pressé selon l'une quelconque des revendications 1 à 7, **caractérisé en ce que** la pression est d'environ 100 à 1300 MPa.

**9.** Corps pressé selon l'une quelconque des revendications 1 à 8, **caractérisé en ce qu'**il a été comprimé avec un sel d'acide gras d'un métal divalent ou trivalent comme adjuvant de compression.

**10.** Corps pressé selon l'une quelconque des revendications 1 à 9, **caractérisé en ce qu'**il a été pressé avec un liant contenant du tanin, de préférence le Quebracho.

**11.** Corps pressé selon l'une quelconque des revendications 1 à 10, **caractérisé en ce qu'**il a été calciné sous vide.

**12.** Corps pressé selon l'une quelconque des revendications 1 à 11, **caractérisé en ce qu'**il contient un pigment colorant.

**13.** Corps pressé avec les composants solides selon l'une quelconque des revendications 1 à 12, dans lequel la teneur en eau du mélange, déterminée par séchage à 160°C, se situe de préférence entre environ 12,4 et environ 22% en poids, toutefois généralement entre environ 8 et 22% en poids.

**14.** Procédé pour la fabrication de corps pressés en forme de plaques présentant une épaisseur inférieure à 700 µm, **caractérisé en ce qu'**on comprime un mélange, contenant au moins un absorbant inorganique, environ 20 à 60% en poids d'au moins un liant, environ 10 à 15% en poids d'eau, déterminé par séchage à 160°C, et un adjuvant de compression, à une pression d'au moins environ 70 MPa et on calcine le corps pressé cru obtenu à des températures d'au moins 500 °C jusqu'à une large élimination de la teneur en eau.

**15.** Procédé selon la revendication 14, **caractérisé en ce que**, dans le mélange, le rapport pondéral de l'absorbant sec et du liant sec est compris entre environ 3,2 et 0,4.

**16.** Procédé selon la revendication 14 ou 15, **caractérisé en ce que** la calcination est réalisée jusqu'à poids constant ou jusqu'à une humidité résiduelle <2%, déterminée à la température de calcination.

**17.** Procédé selon l'une quelconque des revendications 14 à 16, **caractérisé en ce qu'**on utilise un ou plusieurs des constituants indiqués dans les revendications 2 à 13 dans les conditions qui y sont indiquées.

**18.** Procédé selon l'une quelconque des revendications 14 à 17, dans lequel la teneur en eau du mélange, déterminée par séchage à 160°C, se situe de préférence entre environ 12,4 et environ 22% en poids, généralement toutefois entre environ 8 et 22% en poids.

**19.** Utilisation du corps pressé selon l'une quelconque des revendications 1 à 13 comme pièce dans des appareils électroniques, tels que des dispositifs d'affichage, en particulier dans les pièces électro-luminescentes.

Fig. 1